# EUROPÄISCHE PATENTSCHRIFT

(11) **EP 2 412 021 B1**
(45) Veröffentlichungstag und Bekanntmachung des Hinweises auf die Patenterteilung: **01.02.2017**
(21) Anmeldenummer: 10710274.1
(22) Anmeldetag: 15.03.2010
(51) Int. Cl.: H01L 25/075, H01L 33/08, H01L 33/22, H01L 33/58, H01L 33/38, H01L 33/50

(54) **LEUCHTDIODE**
LIGHT EMITTING DIODE
DIODE LUMINESCENTE

(30) Priorität: 25.03.2009 DE 102009001844; 06.05.2009 DE 102009020127
(43) Veröffentlichungstag der Anmeldung: 01.02.2012
(73) Patentinhaber: OSRAM Opto Semiconductors GmbH, 93055 Regensburg (DE)
(72) Erfinder: SABATHIL, Matthias, 93059 Regensburg (DE); KOCUR, Simon, 81737 München (DE); GRÖTSCH, Stefan, 93077 Lengfeld - Bad Abbach (DE)
(74) Vertreter: Epping - Hermann - Fischer
(86) Internationale Anmeldenummer: PCT/EP2010/053304
(87) Internationale Veröffentlichungsnummer: WO 2010/108811

(56) Entgegenhaltungen:
- WO-A1-00/65665
- WO-A1-2006/062588
- WO-A2-2009/048704
- DE-A1- 10 354 936
- DE-A1-102004 052 245
- US-A1- 2006 054 905
- US-A1- 2006 145 137
- US-A1- 2007 221 867

## Beschreibung

Es wird eine Leuchtdiode angegeben.

Es wurde festgestellt, dass die interne Effizienz bei der Erzeugung von elektromagnetischer Strahlung für Leuchtdioden, die beispielsweise auf dem Materialsystem InGaN basieren, mit größer werdender Wellenlänge der erzeugten elektromagnetischen Strahlung von zirka 80 % bei einer Wellenlänge von 400 nm auf zirka 30 % bei einer Wellenlänge von 540 nm absinkt. Das heißt, die interne Effizienz für Leuchtdioden, die geeignet sind, grünes Licht zu erzeugen, ist im Vergleich zu Leuchtdioden, welche Strahlung aus dem UV-Bereich oder blaues Licht emittieren, sehr gering.

Eine Möglichkeit, um die interne Effizienz von Leuchtdioden zu erhöhen, die geeignet sind, grünes Licht abzustrahlen, könnte nun darin bestehen, die Zahl der elektrisch gepumpten Quantentöpfe zu erhöhen. Es hat sich jedoch gezeigt, dass diesem Ansatz zur Lösung des beschriebenen Problems aufgrund der ungleichmäßigen Ladungsträgerverteilung im elektrischen Betrieb der Leuchtdiode enge Grenzen gesetzt sind. Nach derzeitigem Kenntnisstand können bei grünes Licht emittierenden InGaN-basierten Leuchtdioden maximal zwei Quantentöpfe vollständig bestromt werden, das Hinzufügen von weiteren Quantentöpfen scheint keinen positiven Einfluss auf die interne Effizienz der Leuchtdiode zu haben.

In der US 2006/145137 A1 wird eine LED mit drei lichtemittierenden Schichten angegeben, wobei eine elektrisch gepumpt wird.

In der WO 2006/062588 A1 wird eine LED mit einem Re-Emitter beschrieben, welcher eine Quantentopfstruktur umfasst.

Eine zu lösende Aufgabe besteht darin, eine Leuchtdiode anzugeben, mit der elektromagnetische Strahlung besonders effizient erzeugt werden kann. Eine weitere zu lösende Aufgabe besteht darin, eine Leuchtdiode anzugeben, mit der insbesondere grünes Licht besonderes effizient erzeugt werden kann.

Die Leuchtdiode umfasst einen ersten Halbleiterkörper. Der Halbleiterkörper ist beispielsweise epitaktisch gewachsen und kann auf dem InGaN-Materialsystem basieren. Der Halbleiterkörper umfasst zumindest einen aktiven Bereich, der elektrisch kontaktiert ist. Im Betrieb der Leuchtdiode wird im aktiven Bereich des ersten Halbleiterkörpers elektromagnetische Strahlung eines ersten Wellenlängenbereichs erzeugt. Die elektromagnetische Strahlung wird dabei mittels eines elektrischen Betreibens des aktiven Bereichs erzeugt. Bei der elektromagnetischen Strahlung des ersten Wellenlängenbereichs handelt es sich beispielsweise um elektromagnetische Strahlung aus dem UV-Bereich und/oder um blaues Licht.

Weiterhin umfasst die Leuchtdiode einen zweiten Halbleiterkörper, der an einer Oberseite des ersten Halbleiterkörpers am ersten Halbleiterkörper befestigt ist. Auch der zweite Halbleiterkörper ist vorzugsweise epitaktisch hergestellt. Der zweite Halbleiterkörper kann auf dem InGaN-Materialsystem oder dem InGaAlP-Materialsystem basieren. Der zweite Halbleiterkörper umfasst einen Re-Emissionsbereich mit einer Mehrfachquantentopfstruktur. Die Bezeichnung Quantentopfstruktur entfaltet dabei keine Bedeutung hinsichtlich der Dimensionalität der Quantisierung. Sie umfasst unter anderem Quantentröge, Quantendrähte und Quantenpunkte sowie jede Kombination der genannten Strukturen.

Im Betrieb der Leuchtdiode wird im Re-Emissionsbereich elektromagnetische Strahlung des ersten Wellenlängenbereichs absorbiert und elektromagnetische Strahlung eines zweiten Wellenlängenbereichs re-emittiert. Der zweite Wellenlängenbereich umfasst dabei bevorzugt elektromagnetische Strahlung, mit größeren Wellenlängen als der erste Wellenlängenbereich. Der zweite Wellenlängenbereich umfasst insbesondere elektromagnetische Strahlung aus dem Wellenlängenbereich von grünem und/oder gelbem und/oder rotem Licht.

Insbesondere im Hinblick auf einen zweiten Halbleiterkörper, der auf InGaAlP basiert, ergibt sich der Vorteil, dass zum einen auf absorbierende Stromspreizungsschichten und elektrische Kontakte verzichtet werden kann. Zum anderen kann der thermisch aktivierte Verluststrom über eine Passivierung der dem ersten Halbleiterkörper zugewandten Oberfläche vermindert werden und damit die Temperaturabhängigkeit der Effizienz verringert werden.

Der zweite Halbleiterkörper ist also vorzugsweise derart angeordnet, dass elektromagnetische Strahlung des ersten Wellenlängenbereichs aus dem ersten Halbleiterkörper in den zweiten Halbleiterkörper eintreten kann. Der zweite Halbleiterkörper ist dazu vorzugsweise auf einer Strahlungsaustrittsfläche des ersten Halbleiterkörpers angeordnet. Ein Großteil der im ersten Halbleiterkörper erzeugten elektromagnetischen Strahlung tritt in den zweiten Halbleiterkörper ein. Unter einem Großteil der elektromagnetischen Strahlung werden dabei wenigstens 50 %, vorzugsweise wenigstens 70 %, besonders bevorzugt wenigstens 85 % der elektromagnetischen Strahlung des ersten Wellenlängenbereichs verstanden. Der zweite Halbleiterkörper ist dazu besonders großflächig ausgeführt und bedeckt vorzugsweise die gesamte Strahlungsaustrittsfläche an der Oberseite des ersten Halbleiterkörpers. Beispielsweise schließen erster und zweiter Halbleiterkörper in lateraler Richtung bündig miteinander ab oder der zweite Halbleiterkörper überragt den ersten Halbleiterkörper in lateraler Richtung. Die laterale Richtung ist dabei jene Richtung, die beispielsweise zu einer epitaktischen Wachstumsrichtung des ersten Halbleiterkörpers senkrecht steht oder die parallel zu einer Schicht des ersten beziehungsweise des zweiten Halbleiterkörpers verläuft.

Ein Verbindungsmaterial ist zwischen dem ersten und dem zweiten Halbleiterkörper angeordnet, wobei das Verbindungsmaterial den ersten und den zweiten Halbleiterkörper mechanisch miteinander verbindet.

Bei dem Verbindungsmaterial kann es sich beispielsweise um ein Halbleitermaterial handeln, aus dem der erste und der zweite Halbleiterkörper gebildet sind. Erster und zweiter Halbleiterkörper sind dann monolithisch miteinander integriert.

Erster und zweiter Halbleiterkörper sind in diesem Fall beispielsweise in einem einzigen epitaktischen Wachstumsprozess hergestellt und damit einstückig ausgebildet. Ferner ist es möglich, dass erster und zweiter Halbleiterkörper durch einen Waferbond-Prozess miteinander verbunden sind. Bei dem Waferbond-Prozess handelt es sich zum Beispiel um ein direktes Bonden (direct bonding) oder ein anodisches Bonden. Die einander zugewandten Oberflächen der beiden Halbleiterkörper weisen dabei keine Aufrauung auf und werden gegebenenfalls vor dem Verbinden jeweils geglättet.

Alternativ ist es möglich, dass es sich bei dem Verbindungsmaterial um ein transparentes, elektrisch leitfähiges Material handelt. Beispielsweise kann es sich bei dem Verbindungsmaterial dann um ein TCO (Transparent Conductive Oxide) -Material handeln. Erster und zweiter Halbleiterkörper können in diesem Fall beispielsweise über anodisches oder direktes Bonden mittels des Verbindungsmaterials miteinander verbunden sein.

Ferner ist es alternativ möglich, dass das Verbindungsmaterial elektrisch isolierend ist. Bei dem Verbindungsmaterial kann es sich dann beispielsweise um ein Silikon, ein hoch-brechendes Silikon mit einem Brechungsindex von größer 1,5, ein Epoxidharz, ein Siliziumoxid oder ein Siliziumnitrid handeln. Erster und zweiter Halbleiterkörper können mittels des Verbindungsmaterials dann durch Kleben oder Bonden miteinander verbunden sein.

Bei der beschriebenen Leuchtdiode ist der Re-Emissionsbereich des zweiten Halbleiterkörpers vorzugsweise nicht elektrisch kontaktiert. Das heißt, elektromagnetische Strahlung im Re-Emissionsbereich, das heißt die elektromagnetische Strahlung des zweiten Wellenlängenbereichs, wird nicht durch ein elektrisches Betreiben der Mehrfachquantentopfstruktur im Re-Emissionsbereich, sondern durch ein optisches Betreiben erzeugt. Das heißt, der Leuchtdiode liegt unter anderem die Erkenntnis zugrunde, dass wenn die Mehrfachquantentopfstruktur nicht elektrisch, sondern optisch gepumpt wird, eine gleichmäßige Ladungsverteilung in der Mehrfachquantentopfstruktur ermöglicht ist. Durch die direkte Anordnung des ersten Halbleiterkörpers, der kurzwelligere elektromagnetische Strahlung im Betrieb erzeugt mit dem zweiten Halbleiterkörper, der langwelligere elektromagnetische Strahlung im Betrieb erzeugt, ist es möglich, einen maximalen Anteil der elektromagnetischen Strahlung des ersten Wellenlängenbereichs für die gleichmäßige Erzeugung von Elektronen-Lochpaaren in der Mehrfachquantentopfstruktur des Re-Emissionsbereichs zu nutzen. Ferner zeichnet sich eine solche Leuchtdiode durch besonders gute spektrale und thermische Eigenschaften aus. Das heißt, der aktive Bereich des ersten Halbleiterkörpers kann beispielsweise besonders gut gekühlt werden, da der zweite Halbleiterkörper als eine Art Wärmespreizer für den ersten Halbleiterkörper wirkt.

Der erste Halbleiterkörper weist an seiner dem zweiten Halbleiterkörper zugewandten Oberseite eine Vielzahl von Auskoppelstrukturen auf. Bei den Auskoppelstrukturen kann es sich beispielsweise um pyramidenförmige oder pyramidenstumpfförmige Erhebungen an der Oberseite des ersten Halbleiterkörpers handeln. Die Auskoppelstrukturen sind mit einem Material gebildet, das vom Material des ersten Halbleiterkörpers verschieden ist. Dabei handelt es sich bei den Auskoppelstrukturen um zusätzliche Strukturen. Die Auskoppelstrukturen bestehen vorzugsweise aus einem Material, dessen optischer Brechungsindex vom Brechungsindex des ersten Halbleiterkörpers um höchstens 30 % abweicht.

Das Verbindungsmaterial umschließt die Auskoppelstrukturen an ihren freiliegenden Außenflächen. Das heißt, das Verbindungsmaterial ist zwischen den ersten und den zweiten Halbleiterkörper eingebracht und bedeckt die Auskoppelstrukturen. Das Verbindungsmaterial kann die Auskoppelstrukturen dann an den freiliegenden Außenflächen der Auskoppelstrukturen vollständig bedecken, so dass die Auskoppelstrukturen in das Verbindungsmaterial eingebettet sind. Es ist dann möglich, dass die Auskoppelstrukturen an der Oberseite des ersten Halbleiterkörpers den zweiten Halbleiterkörper nicht berühren, sondern dass zwischen den Auskoppelstrukturen und dem zweiten Halbleiterkörper Verbindungsmaterial angeordnet ist.

Insgesamt ermöglichen es die Auskoppelstrukturen, dass elektromagnetische Strahlung des ersten Wellenlängenbereichs mit einer größeren Wahrscheinlichkeit aus dem ersten Halbleiterkörper austreten und in den zweiten Halbleiterkörper eintreten kann, als dies ohne die Auskoppelstrukturen der Fall wäre. Die Auskoppelstrukturen sorgen beispielsweise dafür, dass die Wahrscheinlichkeit für eine Totalreflexion der elektromagnetischen Strahlung aus dem ersten Wellenlängenbereich an der Grenzfläche zwischen erstem Halbleiterkörper und zweitem Halbleiterkörper reduziert ist.

Gemäß zumindest einer Ausführungsform der Leuchtdiode weist der zweite Halbleiterkörper an seiner dem ersten Halbleiterkörper abgewandten Oberseite und/oder seiner dem ersten Halbleiterkörper zugewandten Unterseite eine Vielzahl von Auskoppelstrukturen auf. Die Auskoppelstrukturen können gleich oder unterschiedlich zu den Auskoppelstrukturen des ersten Halbleiterkörpers ausgebildet sein. Das heißt, die Auskoppelstrukturen können aus dem Material des zweiten Halbleiterkörpers strukturiert sein und damit aus dem Material des zweiten Halbleiterkörpers bestehen. Es ist jedoch auch möglich, dass die Auskoppelstrukturen aus einem Material bestehen, das vom Material des zweiten Halbleiterkörpers verschieden ist.

Bevorzugt weist der zweite Halbleiterkörper an seiner dem ersten Halbleiterkörper abgewandten Oberseite und seiner dem ersten Halbleiterkörper zugewandten Unterseite eine Vielzahl von Auskoppelstrukturen auf. Die Auskoppelstrukturen an der Unterseite des zweiten Halbleiterkörpers verringern vorteilhaft Fresnel-Verluste am Interface zwischen zweitem Halbleiterkörper und Verbindungsmaterial.

Die Auskoppelstrukturen des zweiten Halbleiterkörpers bestehen in einer Ausführungsform aus einem Material, dessen optischer Brechungsindex vom optischen Brechungsindex des zweiten Halbleiterkörpers um höchstens 30 % abweicht.

Die Auskoppelstrukturen des zweiten Halbleiterkörpers erhöhen die Wahrscheinlichkeit für einen Lichtaustritt aus dem zweiten Halbleiterkörper heraus.

Bei dem austretenden Licht kann es sich dabei um elektromagnetische Strahlung aus dem ersten oder dem zweiten Wellenlängenbereich handeln. Das heißt, die Leuchtdiode kann Mischlicht aus dem ersten und dem zweiten Wellenlängenbereich abstrahlen. Bei dem Mischlicht kann es sich zum Beispiel um weißes Licht handeln.

Es ist aber auch möglich, dass die Leuchtdiode überwiegend elektromagnetische Strahlung aus dem zweiten Wellenlängenbereich abstrahlt. Das heißt, der überwiegende Teil - zum Beispiel wenigstens 90 % - der elektromagnetischen Strahlung aus dem ersten Wellenlängenbereich, die in den zweiten Halbleiterkörper eingetreten ist, wird im zweiten Halbleiterkörper absorbiert. Auf diese Weise ist es möglich, dass die Leuchtdiode beispielsweise farbreines grünes, gelbes oder rotes Licht emittiert.

Gemäß zumindest einer Ausführungsform der Leuchtdiode enthält oder besteht das Material der Auskoppelstrukturen des ersten und/oder des zweiten Halbleiterkörpers aus einem der folgenden Stoffe: Titanoxid, Zinkselenid, Aluminiumnitrid, Siliziumcarbid, Bornitrid und/oder Tantaloxid. Diese Stoffe zeichnen sich dadurch aus, dass sie einen optischen Brechungsindex aufweisen, der um höchstens 30 % vom Brechungsindex eines InGaN-basierten Halbleiterkörpers abweichen.

Gemäß zumindest einer Ausführungsform der Leuchtdiode ist eine Spiegelschicht an der dem zweiten Halbleiterkörper abgewandten Unterseite des ersten Halbleiterkörpers befestigt. Bei der Spiegelschicht handelt es sich beispielsweise um einen dielektrischen Spiegel, einen Bragg-Spiegel, einen metallischen Spiegel oder um eine Kombination der genannten Spiegel. Die Spiegelschicht ist vorgesehen, elektromagnetische Strahlung des ersten Wellenlängenbereichs in Richtung des zweiten Halbleiterkörpers zu reflektieren. Auf diese Weise ist es ermöglicht, dass ein besonders großer Anteil der elektromagnetischen Strahlung des ersten Wellenlängenbereichs in den zweiten Halbleiterkörper eintritt. Ferner kann die Spiegelschicht auch elektromagnetische Strahlung des zweiten Wellenlängenbereichs, die aus dem zweiten Halbleiterkörper in Richtung des ersten Halbleiterkörpers abgestrahlt wird, in Richtung des zweiten Halbleiterkörpers und damit aus der Leuchtdiode hinaus reflektieren.

Gemäß zumindest einer Ausführungsform der Leuchtdiode umfasst die Mehrfachquantenstruktur des Re-Emissionsbereichs wenigstens 20 Quantentopfschichten. Die Quantentopfschichten sind beispielsweise entlang einer Wachstumsrichtung des zweiten Halbleiterkörpers übereinander angeordnet und durch Barriereschichten voneinander getrennt. Es hat sich dabei gezeigt, dass eine so große Anzahl von Quantentopfschichten mittels optischen Pumpens gleichmäßig mit Ladungsträgern besetzt werden kann und sich die Effizienz der Erzeugung von elektromagnetischer Strahlung des zweiten Wellenlängenbereichs aufgrund der hohen Anzahl von Quantentopfschichten merklich erhöht. Insbesondere bei der Vollkonversion von blauem Licht oder UV-Strahlung zu grünem Licht ist die Zahl der Quantentopfschichten (auch Quantenfilme) wichtig für die Effizienz der Lichterzeugung, da Photonen nur in den Quantentopfschichten absorbiert werden und bei einer hohen Zahl von Quantentopfschichten ein ausreichender Absorptionsquerschnitt gegeben ist. Des Weiteren ergibt sich bei einer hohen Anzahl von Quantentopfschichten aufgrund der geringeren Ladungsträgerdichte in den einzelnen Töpfen eine vorteilhafte Verschiebung des Effizienz-Maximums zu höheren Strömen. Daher kann die Vollkonversion bei hohen Stromdichten von > 100 A/cm² effizienter als eine direkt elektrisch gepumpte grüne Leuchtdiode sein.

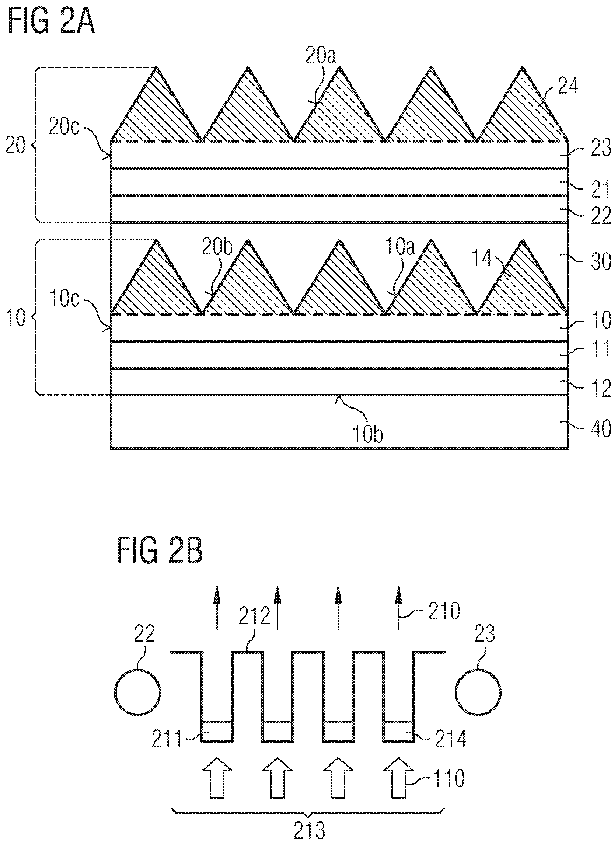

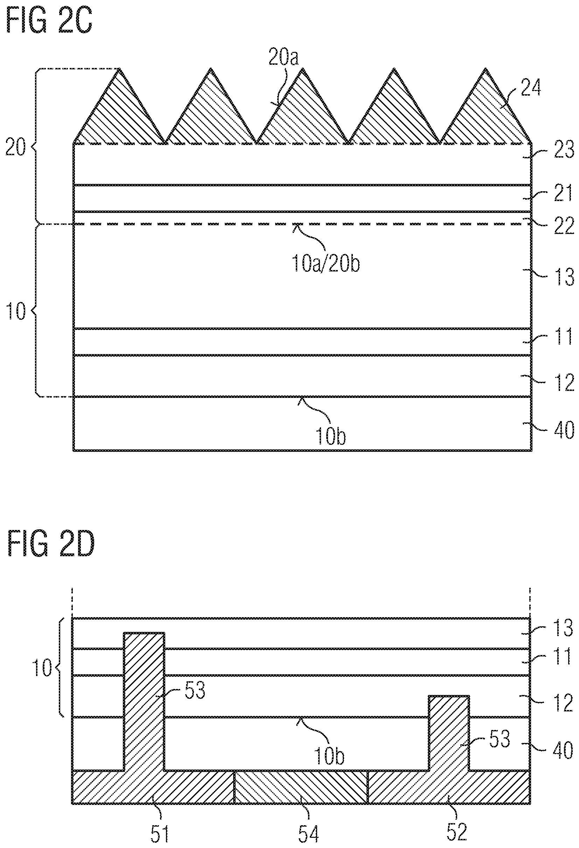

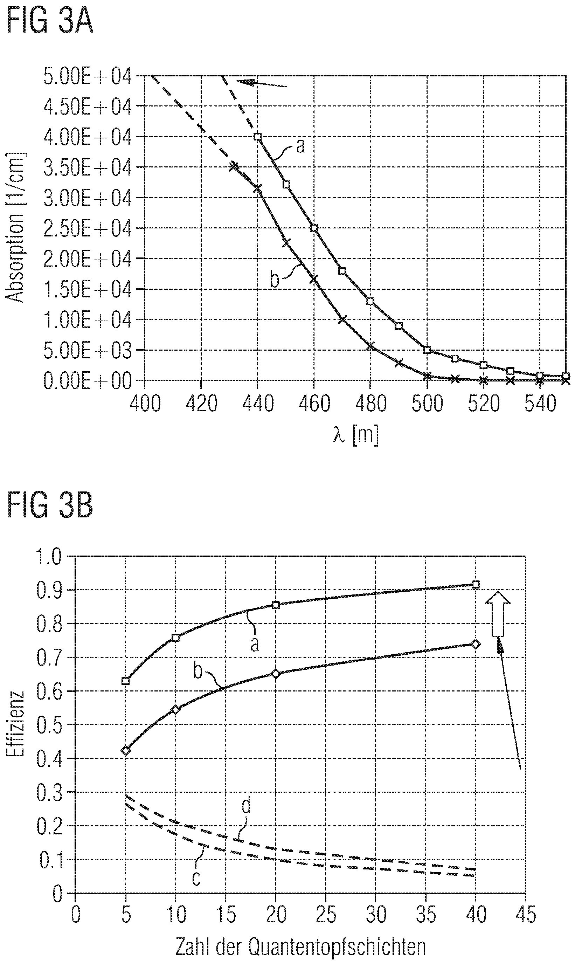

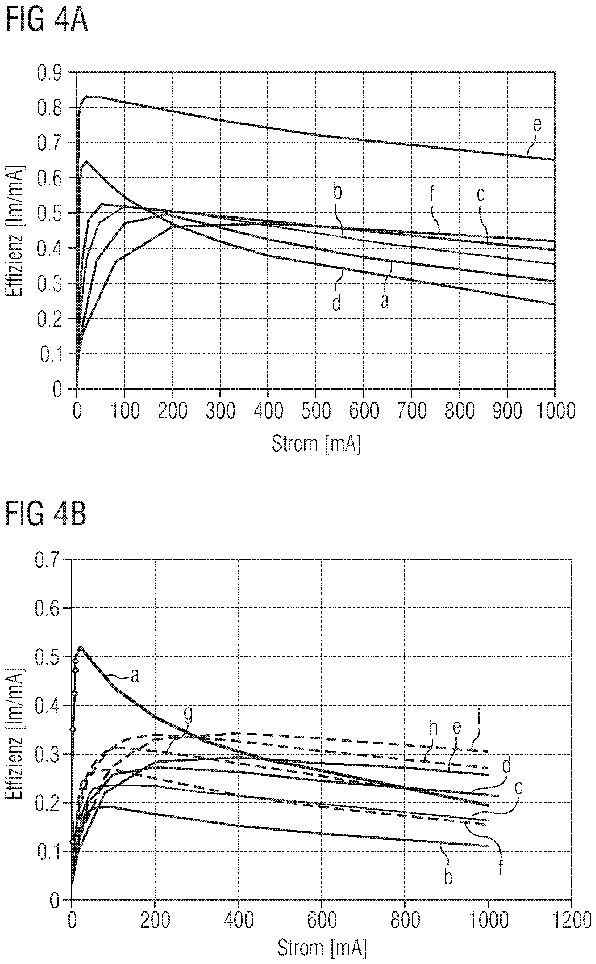

Im Folgenden wird die hier beschriebene Leuchtdiode anhand von Ausführungsbeispielen und den dazugehörigen Figuren näher erläutert.

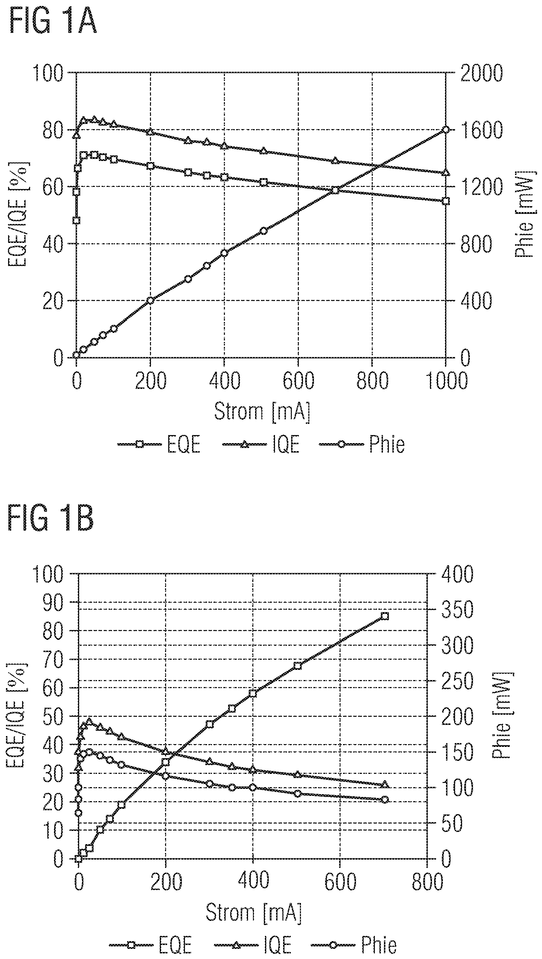

- Die Figuren 1A und 1B: zeigen anhand graphischer Auftragungen die Effizienz von elektrisch betriebenen blauen und grünen Leuchtdioden.
- Mit den Figuren 2A, 2B, 2C und 2D: sind anhand schematischer Schnittdarstellungen Ausführungsbeispiele von hier beschriebenen Leuchtdioden näher erläutert.
- Anhand der graphischen Auftragungen der Figuren 3A, 3B, 4A, 4B: sind Eigenschaften von hier beschriebenen Leuchtdioden näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1A zeigt anhand einer graphischen Auftragung die externe Effizienz (EQE) mit optischen Verlusten und die interne Effizienz ohne optische Verluste (IQE) für eine Leuchtdiode, die elektromagnetische Strahlung bei einer Peakwellenlänge von 435 nm, also blaues Licht, emittiert. Die Leuchtdiode wird dabei elektrisch betrieben. Wie aus der Figur 1A ersichtlich ist, beträgt die interne Effizienz bis zu über 80 %.

Die Figur 1B zeigt anhand einer graphischen Auftragung die externe Effizienz (EQE) und die interne Effizienz (IQE) für eine elektrisch betriebene Leuchtdiode, welche grünes Licht bei einer Peakwellenlänge von 540 nm emittiert. Wie in der Figur 1B zu erkennen ist, beträgt die maximale interne Effizienz unter 50 %.

Insgesamt sind elektrisch gepumpte grüne Leuchtdioden elektrisch gepumpten blauen Leuchtdioden oder UV-Strahlung emittierenden Leuchtdioden bezüglich ihrer Effizienz unterlegen.

Die Figur 2A zeigt ein erstes Ausführungsbeispiel einer hier beschriebenen Leuchtdiode anhand einer schematischen Schnittdarstellung. Die Leuchtdiode der Figur 2A umfasst einen ersten Halbleiterkörper 10 und einen zweiten Halbleiterkörper 20. Erster Halbleiterkörper 10 und zweiter Halbleiterkörper 20 sind übereinander gestapelt angeordnet. Der zweite Halbleiterkörper 20 folgt dem ersten Halbleiterkörper 10 an dessen Oberseite 10a nach. An der Oberseite 10a befindet sich auch die Strahlungsäustrittsfläche des ersten Halbleiterkörpers 10, durch die die gesamte oder ein Großteil der aus dem ersten Halbleiterkörper 10 austretenden elektromagnetischen Strahlung 110 austritt.

Der erste Halbleiterkörper 10 umfasst einen p-dotierten Bereich 12 und einen n-dotierten Bereich 13. Zwischen dem p-dotierten Bereich 12 und dem n-dotierten Bereich 13 ist der aktive Bereich 11 angeordnet. Der aktive Bereich 11 wird elektrisch betrieben, die elektrischen Anschlüsse sind in der Figur 2A nicht gezeigt (siehe dazu die Figur 2D). Beispielsweise umfasst der aktive Bereich 11 einen pn-Übergang, eine Einfachquantentopfstruktur oder eine Mehrfachquantentopfstruktur. An seiner Oberseite 10a weist der erste Halbleiterkörper 10 Auskoppelstrukturen 14 auf. Die Auskoppelstrukturen 14 sind mit einem Material gebildet, das vom Material des ersten Halbleiterkörpers 10 verschieden ist.

Der zweite Halbleiterkörper 20 umfasst einen n-dotierten Bereich 22, einen p-dotierten Bereich 23 und einen Re-Emissionsbereich 21, der zwischen den beiden Bereichen angeordnet ist. Der Re-Emissionsbereich 21 umfasst eine Mehrfachquantentopfstruktur. Der Re-Emissionsbereich 21 ist nicht elektrisch angeschlossen und wird nicht elektrisch betrieben.

An seiner Oberseite 20a umfasst der zweite Halbleiterkörper 20 Auskoppelstrukturen 24, die vorliegend mittels KOH-Ätzung in den Halbleiterkörper 20 strukturiert sind. Auch die Auskoppelstrukturen 24 können aus anderen Materialien, wie sie weiter oben beschrieben sind, gebildet sein. Auch an der Unterseite 20b des zweiten Halbleiterkörpers 20 können Auskoppelstrukturen 24 angeordnet sein (in der Figur nicht gezeigt).

Zwischen erstem Halbleiterkörper 10 und zweitem Halbleiterkörper 20 ist ein Verbindungsmaterial 30 angeordnet, das vorliegend Silikon enthält oder aus Silikon besteht. Das Verbindungsmaterial 30 umschließt die Auskoppelstrukturen 14 des ersten Halbleiterkörpers 10 an ihren freiliegenden Außenflächen vollständig. Das Verbindungsmaterial 30 ist vorliegend elektrisch isolierend und stellt eine mechanische Verbindung zwischen den beiden Halbleiterkörpern dar.

Erster Halbleiterkörper 10 und zweiter Halbleiterkörper 20 sind vorliegend getrennt voneinander epitaktisch hergestellt und nachträglich mittels des Verbindungsmaterials 30 miteinander verbunden. An ihren Seitenflächen 20c und 10c schließen zweiter Halbleiterkörper 20 und erster Halbleiterkörper 10 bündig miteinander ab, so dass sich die Halbleiterkörper 10, 20 gegenseitig lateral nicht überragen.

An der dem zweiten Halbleiterkörper 20 abgewandten Unterseite 10b des ersten Halbleiterkörpers 10 ist eine Spiegelschicht 40 angeordnet, die vorliegend als metallischer Spiegel ausgebildet ist, der beispielsweise aus Aluminium oder Silber besteht. Die Spiegelschicht 40 ist sowohl zur Reflexion von elektromagnetischer Strahlung 110 aus dem ersten Wellenlängenbereich und elektromagnetischer Strahlung 210 aus dem zweiten Wellenlängenbereich geeignet.

In der schematischen Schnittdarstellung der Figur 2B ist die Mehrfachquantentopfstruktur 213 des Re-Emissionsbereichs 21 näher erläutert. Die Mehrfachquantentopfstruktur 213 umfasst eine Vielzahl von Quantentopfschichten 211, die durch Barriereschichten 212 voneinander getrennt sind. Elektromagnetische Strahlung des ersten Wellenlängenbereichs 110 führt zu einer Verteilung von Ladungsträgern 214 in den Quantentopfstrukturen, die aufgrund des optischen Pumpens, gleichmäßig ist.

In Verbindung mit der Figur 2C ist anhand einer schematischen Schnittdarstellung ein weiteres Ausführungsbeispiel einer hier beschriebenen Leuchtdiode näher erläutert. In diesem Ausführungsbeispiel sind erster Halbleiterkörper 10 und zweiter Halbleiterkörper 20 monolithisch integriert. Das heißt beispielsweise, sie sind in einer einzigen Epitaxieanlage aufeinander epitaktisch abgeschieden. Ferner ist es möglich, dass erster Halbleiterkörper 10 und zweiter Halbleiterkörper 20 mittels eines Waferbond-Prozesses miteinander verbunden sind. Das Verbindungsmaterial 30 ist im Ausführungsbeispiel durch das Halbleitermaterial 13, 22 von erstem Halbleiterkörper 10 und zweitem Halbleiterkörper 20 gebildet. Vorteilhaft ist die optische Kopplung zwischen dem aktiven Bereich 11 und dem Re-Emissionsbereich 21 in dieser Ausführungsform besser als beim Ausführungsbeispiel, das beispielsweise in Verbindung mit der Figur 2A beschrieben ist. Nachteilig ist die kompliziertere Herstellung des in Verbindung mit der Figur 2C gezeigten Ausführungsbeispiels.

Anhand der schematischen Schnittdarstellung 2D ist eine Möglichkeit zur elektrischen Kontaktierung des aktiven Bereichs 11 des ersten Halbleiterkörpers 10 schematisch erläutert. Von der Unterseite 10b des ersten Halbleiterkörpers 10 her sind vorliegend Kanäle 53 durch die Spiegelschicht hindurch in den Halbleiterkörper 10 eingebracht, die mit einem elektrisch leitenden Material gefüllt sind, das an der dem Halbleiterkörper 10 abgewandten Seite der Spiegelschicht 40 elektrische Kontaktstellen 51, 52 bildet. Neben der gezeigten Ausführungsform sind auch andere Anschlussmöglichkeit zur elektrischen Kontaktierung der aktiven Schicht 11 des ersten Halbleiterkörpers 10 denkbar.

Die graphische Auftragung der Figur 3A zeigt die Absorption in der Mehrfachquantentopfstruktur 213 des Re-Emissionsbereichs 21 für das Ausführungsbeispiel der Figur 2C (Kurve a) und das Ausführungsbeispiel der Figur 2A (Kurve b) in Abhängigkeit der Wellenlänge λ der in der aktiven Schicht 11 erzeugten elektromagnetischen Strahlung. Dabei ist zu erkennen, dass die Absorption für elektromagnetische Strahlung im Wellenlängenbereich von 400 nm, das heißt im UV-Bereich, optimal ist. Vorzugsweise wird in der aktiven Schicht 11 daher elektromagnetische Strahlung aus dem UV-Bereich erzeugt.

Die Figur 3B zeigt anhand einer graphischen Auftragung die Effizienz aufgetragen gegen die Zahl der Quantentopfschichten in der Mehrfachquantentopfstruktur 213. Die Kurven a, b zeigen dabei die Effizienz für die Ausführungsbeispiele der Figuren 2C beziehungsweise 2A. Die Kurven c und d zeigen den Anteil an unkonvertierter Pumpstrahlung, die noch aus dem System austritt für die Ausführungsbeispiele der Figuren 2C beziehungsweise 2A. Zusätzlich gibt es aber noch optische Verluste durch Absorption, die bei der Variante gemäß Figur 2C höher sind, als bei der Variante gemäß Figur 2A. Es ist zu erkennen, dass die Effizienz mit der Zahl der Quantentopfschichten 211 in der Mehrfachquantentopfstruktur 213 ansteigt. Dabei ist zu beachten, dass die monolithische Struktur, wie sie in Verbindung mit der Figur 2C näher beschrieben ist, eine höhere Effizienz aufweist als die Struktur der Figur 2A, bei der Silikon mit einem Brechungsindex von ungefähr 1,4 als Verbindungsmaterial 30 zum Verbinden von erstem Halbleiterkörper 10 und zweitem Halbleiterkörper 20 Verwendung findet.

Die Figur 4A zeigt anhand einer graphischen Auftragung die Effizienz gegen die Stromstärke, mit der der aktive Bereich betrieben wird. Es handelt sich dabei um die interne Effizienz, ohne optische Verluste. Da die optischen Verluste nicht berücksichtigt werden, bezieht sich die graphische Auftragung der Figur 4A sowohl auf das Ausführungsbeispiel der Figur 2A als auch auf das Ausführungsbeispiel der Figur 2C. Die Kurve a zeigt die Effizienz für fünf optisch gepumpte Quantentopfschichten, die Kurve b für zehn, die Kurve c für 20 und die Kurve f für 40 Quantentopfschichten 211 in der Mehrfachquantentopfstruktur 213. Die Kurve e zeigt die Effizienz des elektrisch gepumpten aktiven Bereichs 11, der UV-Strahlung erzeugt. Wie aus der Figur 4A ersichtlich ist, erhöht sich die interne Effizienz für größere Stromstärken. Für Stromstärken über 200 mA liegen sämtliche Kurven für optisch gepumpte Mehrfachquantentopfstrukturen über der Effizienz für eine elektrisch gepumpte Quantentopfstruktur, wie sie in der Kurve d aufgetragen ist.

Die Figur 4B zeigt eine graphische Auftragung der Effizienz gegen den angelegten Strom, wobei optische Verluste berücksichtigt werden. Die gestrichelten Linien beziehen sich dabei auf monolithisch integrierte Ausführungsformen, wie sie in Verbindung mit der Figur 2C gezeigt sind. Die durchgezogenen Linien beziehen sich auf Ausführungsformen, bei denen erster Halbleiterkörper 10 und zweiter Halbleiterkörper 20 getrennt voneinander gefertigt sind, wie sie in Verbindung mit der Figur 2A beschrieben sind. Als allgemeiner Trend ist zu erkennen, dass aufgrund der geringeren optischen Verluste die Effizienz für monolithisch integrierte Leuchtdioden verbessert ist. Diese sind aber in ihrem Herstellungsverfahren aufwändiger.

Die Kurve a zeigt die Effizienz eines elektrisch gepumpten aktiven Bereichs mit einer einzigen Quantentopfschicht, der grünes Licht erzeugt zum Vergleich. Die Kurve b zeigt die Situation für fünf Quantentopfschichten, die Kurve c für zehn Quantentopfschichten, die Kurve d für 20 Quantentopfschichten und die Kurve e für 40 Quantentopfschichten, jeweils mit Silikon als Verbindungsmaterial 30 zwischen erstem Halbleiterkörper 10 und zweitem Halbleiterkörper 20.

Die Kurve f zeigt die Situation für fünf Quantentopfschichten, die Kurve g für zehn Quantentopfschichten, die Kurve h für 20 Quantentopfschichten und die Kurve i für 40 Quantentopfschichten für den Fall, dass erster Halbleiterkörper 10 und zweiter Halbleiterkörper monolithisch miteinander integriert sind. Insgesamt weist die Leuchtdiode ab einer Zahl von zirka 20 optisch gepumpten Quantentopfschichten 211 im Re-Emissionsbereich 21 eine höhere Effizienz als die elektrisch gepumpte Quantentopfschicht auf. Die Erfindung ist nicht durch die Beschreibung anhand der Ausführungsbeispiele auf diese beschränkt. Vielmehr umfasst die Erfindung jede Kombination von Merkmalen in den Patentansprüchen.

Diese Patentanmeldung beansprucht die Prioritäten der deutschen Patentanmeldungen 102009001844.1 und 102009020127. 0.

## Patentansprüche

1. Leuchtdiode mit
- einem ersten Halbleiterkörper (10), der zumindest einen aktiven Bereich (11) umfasst, der elektrisch kontaktiert ist, wobei im Betrieb der Leuchtdiode im aktiven Bereich (11) elektromagnetische Strahlung (110) eines ersten Wellenlängenbereichs erzeugt wird, und
- einem zweiten Halbleiterkörper (20), der an einer Oberseite (10a) des ersten Halbleiterkörpers (10) am ersten Halbleiterkörper (10) befestigt ist, wobei der zweite Halbleiterkörper (20) einen Re-Emissionsbereich (21) mit einer Mehrfachquantentopfstruktur (213) aufweist und wobei im Betrieb der Leuchtdiode im Re-Emissionsbereich (21) elektromagnetische Strahlung (110) des ersten Wellenlängenbereichs absorbiert und elektromagnetische Strahlung eines zweiten Wellenlängenbereichs (220) re-emittiert wird, und
- einem Verbindungsmaterial (30), das zwischen erstem (10) und zweitem Halbleiterkörper (20) angeordnet ist, wobei das Verbindungsmaterial (30) den ersten (10) und den zweiten Halbleiterkörper (20) mechanisch miteinander verbindet, wobei
- der erste Halbleiterkörper (10) an seiner dem zweiten Halbleiterkörper (20) zugewandten Oberseite (10a) eine Vielzahl von Auskoppelstrukturen (14) aufweist, **dadurch gekennzeichnet, dass**
- das Verbindungsmaterial (30) die Auskoppelstrukturen (14) an ihren freiliegenden Außenflächen umschließt, und
- die Auskoppelstrukturen (14) mit einem Material gebildet sind, das vom Material des ersten Halbleiterkörpers (10) verschieden ist.

2. Leuchtdiode gemäß dem vorherigen Anspruch,
bei der das Verbindungsmaterial (30) elektrisch isolierend ist.

3. Leuchtdiode gemäß dem vorherigen Anspruch,
bei der das Verbindungsmaterial (30) Silikon ist oder ein Silikon enthält.

4. Leuchtdiode gemäß Anspruch 1,
bei der die Auskoppelstrukturen (14) aus einem Material bestehen, dessen Brechungsindex vom Brechungsindex des ersten Halbleiterkörpers (10) um höchstens 30 % abweicht.

5. Leuchtdiode gemäß einem der vorherigen Ansprüche,
bei der der zweite Halbleiterkörper (20) an seiner dem ersten Halbleiterkörper abgewandten Oberseite (20a) und/oder seiner dem ersten Halbleiterkörper zugewandten Unterseite (20b) eine Vielzahl von Auskoppelstrukturen (24) aufweist.

6. Leuchtdiode gemäß dem vorherigen Anspruch,
bei der die Auskoppelstrukturen (24) aus einem Material bestehen, dessen Brechungsindex vom Brechungsindex des zweiten Halbleiterkörpers (20) um höchstens 30 % abweicht.

7. Leuchtdiode gemäß einem der vorherigen Ansprüche,
bei der das Material der Auskoppelstrukturen (14, 24) einen der folgenden Stoffe enthält oder hieraus besteht: TiO2, ZnS, AlN, SiC, BN, Ta2O5.

8. Leuchtdiode gemäß einem der vorherigen Ansprüche,
bei der eine Spiegelschicht (40) an der dem zweiten Halbleiterkörper (20) abgewandten Unterseite (10b) des ersten Halbleiterkörpers (10) am ersten Halbleiterkörper (10) befestigt ist.

9. Leuchtdiode gemäß einem der vorherigen Ansprüche,
bei der die Auskoppelstrukturen (24) mit einem Material gebildet sind, das vom Material des ersten Halbleiterkörpers (10) und vom Material des zweiten Halbleiterkörpers (20) verschieden ist.

10. Leuchtdiode gemäß einem der vorherigen Ansprüche,
bei der der erste Wellenlängenbereich elektromagnetische Strahlung aus dem Wellenlängenbereich von UV-Strahlung und/oder blauem Licht umfasst.

11. Leuchtdiode gemäß dem vorherigen Anspruch,
bei der der zweite Wellenlängenbereich elektromagnetische Strahlung aus dem Wellenlängenbereich von grünem Licht umfasst.

12. Leuchtdiode gemäß einem der vorherigen Ansprüche,
bei der die Mehrfachquantentopfstruktur (213) des Re-Emissionsbereichs wenigstens 20 Quantentopfschichten (211) aufweist.

13. Leuchtdiode gemäß einem der vorherigen Ansprüche,
bei der die Auskoppelstrukturen (14) pyramidenförmige oder pyramidenstumpfförmige Erhebungen an der Oberseite des ersten Halbleiterkörpers (10) sind.

## Claims

1. Light-emitting diode comprising
- a first semiconductor body (10), which comprises at least one active region (11) which is electrically contact-connected, wherein electromagnetic radiation (110) in a first wavelength range is generated in the active region (11) during the operation of the light-emitting diode, and
- a second semiconductor body (20), which is fixed to the first semiconductor body (10) at a top side (10a) of the first semiconductor body (10), wherein the second semiconductor body (20) has a re-emission region (21) with a multiple quantum well structure (213), and wherein electromagnetic radiation (110) in the first wavelength range is absorbed and electromagnetic radiation in a second wavelength range (220) is re-emitted in the re-emission region (21) during the operation of the light-emitting diode, and
- a connecting material (30) arranged between the first (10) and second semiconductor body (20), wherein the connecting material (30) mechanically connects the first (10) and the second semiconductor body (20) to one another, wherein
- the first semiconductor body (10) has a multiplicity of coupling-out structures (14) at its top side (10a) facing the second semiconductor body (20) **characterized in that**
- the connecting material (30) encloses the coupling-out structures (14) at their exposed outer areas, and
- the coupling-out structures (14) are formed with a material which is different from the material of the first semiconductor body (10).

2. Light-emitting diode according to the preceding claim, wherein the connecting material (30) is electrically insulating.

3. Light-emitting diode according to the preceding claim,
wherein the connecting material (30) is silicone or contains a silicone.

4. Light-emitting diode according to Claim 1,
wherein the coupling-out structures (14) consist of a material whose refractive index deviates by at most 30% from the refractive index of the first semiconductor body (10).

5. Light-emitting diode according to any of the preceding claims,
wherein the second semiconductor body (20) has a multiplicity of coupling-out structures (24) at its top side (20a) remote from the first semiconductor body and/or its underside (20b) facing the first semiconductor body.

6. Light-emitting diode according to the preceding claim,
wherein the coupling-out structures (24) consist of a material whose refractive index deviates by at most 30% from the refractive index of the second semiconductor body (20).

7. Light-emitting diode according to any of the preceding claims,
wherein the material of the coupling-out structures (14, 24) contains or consists of one of the following substances: TiO₂, ZnS, AlN, SiC, BN, Ta₂O₅.

8. Light-emitting diode according to any of the preceding claims,
wherein a mirror layer (40) is fixed to the first semiconductor body (10) at the underside (10b) of the first semiconductor body (10) remote from the second semiconductor body (20).

9. Light-emitting diode according to any of the preceding claims,
wherein the coupling-out structures (24) are formed with a material which is different from the material of the first semiconductor body (10) and from the material of the second semiconductor body (20).

10. Light-emitting diode according to any of the preceding claims,
wherein the first wavelength range comprises electromagnetic radiation from the wavelength range of UV radiation and/or blue light.

11. Light-emitting diode according to the preceding claim,
wherein the second wavelength range comprises electromagnetic radiation from the wavelength range of green light.

12. Light-emitting diode according to any of the preceding claims,
wherein the multiple quantum well structure (213) of the re-emission region has at least 20 quantum well layers (211).

13. Light-emitting diode according to any of the preceding claims,
wherein the coupling-out structures (14) are pyramid-shaped elevations, or elevations in the shape of truncated pyramids, at the top side of the first semiconductor body (10).

## Revendications

1. Diode électroluminescente comportant :
- un premier corps à semi-conducteur (10) comprenant au moins une zone active (11) avec laquelle un contact électrique est établi, dans laquelle, lors du fonctionnement de la diode électroluminescente dans la zone active (11), un rayonnement électromagnétique (110) se situant dans une première plage de longueurs d'onde est généré, et
- un deuxième corps à semi-conducteur (20) fixé au premier corps à semi-conducteur (10) sur une première face supérieure (10a) du premier corps à semi-conducteur (10), dans lequel le deuxième corps à semi-conducteur (20) présente une zone de réémission (21) ayant une structure de puits quantiques multiples (213) et dans laquelle, lors du fonctionnement de la diode électroluminescente dans la zone de réémission (21), un rayonnement électromagnétique (110) se situant dans la première plage de longueurs d'onde est absorbé et un rayonnement électromagnétique se situant dans une deuxième plage de longueurs d'onde (220) est réémis, et
- un matériau de liaison (30) qui est disposé entre les premier (10) et deuxième (20) corps à semi-conducteur, dans laquelle le matériau de liaison (30) relie mécaniquement l'un à l'autre les premier (10) et deuxième (20) corps à semi-conducteur, dans laquelle
- le premier corps à semi-conducteur (10) présente sur sa face supérieure (10a) tournée vers le deuxième corps à semi-conducteur (20) une pluralité de structures de couplage de sortie (14), **caractérisée en ce que**
- le matériau de liaison (30) entoure les structures de couplage de sortie (14) au niveau de leurs surfaces externes libres, et
- les structures de couplage de sortie (14) sont formées d'un matériau qui est différent du matériau du premier corps à semi-conducteur (10).

2. Diode électroluminescente selon la revendication précédente, dans laquelle le matériau de liaison (30) est électriquement isolant.

3. Diode électroluminescente selon la revendication précédente, dans laquelle le matériau de liaison (30) est constitué de silicium ou contient un silicium.

4. Diode électroluminescente selon la revendication 1,
dans laquelle les structures d'extraction (14) sont constituées d'un matériau dont l'indice de réfraction diffère de l'indice de réfraction du premier corps à semi-conducteur (10) d'au plus 30 %.

5. Diode électroluminescente selon l'une quelconque des revendications précédentes,
dans laquelle le deuxième corps à semi-conducteur (20) présente sur sa face supérieure (20a) tournée à l'opposé du premier corps à semi-conducteur et/ou sur sa face inférieure (20b) tournée vers le premier corps à semi-conducteur une pluralité de structures d'extraction (24).

6. Diode électroluminescente selon la revendication précédente,
dans laquelle les structures d'extraction (24) sont constituées d'un matériau dont l'indice de réfraction diffère de l'indice de réfraction du deuxième corps à semi-conducteur (20) d'au plus 30 %.

7. Diode électroluminescente selon l'une quelconque des revendications précédentes,
dans laquelle le matériau des structures d'extraction (14, 24) contient ou est constitué de l'un des matériaux suivants : TiO2, ZnS, AlN, SiC, BN, Ta2O5.

8. Diode électroluminescente selon l'une quelconque des revendications précédentes,
dans laquelle une couche formant miroir (40) est fixée sur le premier corps à semi-conducteur (10) sur la face inférieure (10b) du corps à semi-conducteur (10) qui est tournée en sens opposé au deuxième corps à semi-conducteur (20).

9. Diode électroluminescente selon l'une quelconque des revendications précédentes,
dans laquelle les structures d'extraction (24) sont formées d'un matériau qui est différent du matériau du premier corps à semi-conducteur (10) et du matériau du deuxième corps à semi-conducteur (20).

10. Diode électroluminescente selon l'une quelconque des revendications précédentes,
dans laquelle la première plage de longueurs d'onde comprend un rayonnement électromagnétique constitué de la plage de longueurs d'onde du rayonnement UV et/ou de la lumière bleue.

11. Diode électroluminescente selon la revendication précédente,
dans laquelle la deuxième plage de longueurs d'onde comprend un rayonnement constitué de la plage de longueurs d'onde de la lumière verte.

12. Diode électroluminescente selon l'une quelconque des revendications précédentes,
dans laquelle la structure à puits quantiques multiples (213) de la zone de réémission comporte au moins 20 couches de puits quantiques (211).

13. Diode électroluminescente selon l'une quelconque des revendications précédentes,
dans laquelle les structures d'extraction (14) sont des protubérances pyramidales ou en forme de tronçons de pyramides sur la face supérieure du premier corps à semi-conducteur (10).
